# EUROPÄISCHE PATENTSCHRIFT

(11) **EP 3 545 729 B1**
(45) Veröffentlichungstag und Bekanntmachung des Hinweises auf die Patenterteilung: **07.05.2025**
(21) Anmeldenummer: 17783478.5
(22) Anmeldetag: 11.10.2017
(51) Int. Cl.: H05K 1/02, H05K 3/32, H05K 3/30, H01R 12/58, G01D 11/00, H01M 10/48

(54) **LEITERPLATTE UND VERFAHREN ZUR HERSTELLUNG DER LEITERPLATTE**
PRINTED CIRCUIT BOARD AND METHOD FOR PRODUCING THE PRINTED CIRCUIT BOARD
CARTE DE CIRCUIT IMPRIMÉ ET PROCÉDÉ DE FABRICATION DE LA CARTE DE CIRCUIT IMPRIMÉ

(30) Priorität: 23.11.2016 DE 102016122577
(43) Veröffentlichungstag der Anmeldung: 02.10.2019
(73) Patentinhaber: Endress+Hauser SE+Co. KG, 79689 Maulburg (DE)
(72) Erfinder: SCHÄUBLE, Harald, 79541 Lörrach (DE); SCHEFFS, Alexander, 79688 Hausen i. W. (DE); MUTTER,Christian, 79588 Huttingen (DE)
(74) Vertreter: Endress + Hauser Group Services (Deutschland) AG+Co. KG
(86) Internationale Anmeldenummer: PCT/EP2017/075922
(87) Internationale Veröffentlichungsnummer: WO 2018/095647

(56) Entgegenhaltungen:
- EP-A1- 1 532 842
- EP-A1- 2 592 913
- DE-A1- 102014 018 986
- DE-U1- 8 503 703
- JP-A- H05 220 277
- US-A- 3 181 974
- US-A- 4 904 192
- US-A- 5 250 371
- US-A1- 2007 229 656
- US-B1- 6 530 804

## Beschreibung

Die Erfindung betrifft eine Leiterplatte mit einer Halterung für eine Batterie, ein Gehäuse mit einer derartigen, darin angeordneten Leiterplatte, sowie ein Verfahren zur Herstellung einer erfindungsgemäßen Leiterplatte.

In der Automatisierungstechnik werden Feldgeräte zur Bestimmung und/oder Überwachung von Prozessgrößen, insbesondere von physikalischen oder chemischen Prozessgrößen, eingesetzt. Ein Feldgerät umfasst typischerweise zumindest eine zumindest teilweise und zumindest zeitweise mit dem Prozess in Berührung kommende Sensoreinheit. Als Feldgeräte werden im Rahmen der vorliegenden Anmeldung im Prinzip alle Messgeräte bezeichnet, die prozessnah eingesetzt werden und die prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeits-messgeräte, usw., welche die entsprechenden Prozessgrößen Füllstand, Durchfluss, Druck, Temperatur, pH-Wert bzw. Leitfähigkeit erfassen. Solche Feldgeräte werden in unterschiedlichen Ausgestaltungen von der E+H Gruppe hergestellt und vertrieben.

Viele Feldgeräte der Automatisierungstechnik sind heute zunehmend nicht mehr mittels eines Kabels oder Drahtes an eine übergeordnete Einheit angeschlossen, sondern kommunizieren mit dieser ausschließlich per Funk, wie beispielsweise WLAN, Bluetooth, Near Field Communication. Dabei kann das Feldgerät auch Teil eines drahtlosen Kommunikationsnetzwerks sein, wie beispielsweise eines Bluetooth, ZigBee, WLAN, GSM, LTE, UMTS - Kommunikationsnetzwerks oder aber auch einer drahtlosen Version eines Feldbusses, insbesondere 802.15.4 basierte Standards wie WirelessHART. Mittels derartiger nicht-kabelgebundener Kommunikationsnetzwerke können dann auch ohne einen kabel- oder drahtgebunden Anschluss des Feldgeräts Messdaten und/oder weitere Informationen (beispielsweise Informationen zur Parametrierung, zur Bedienung und/oder zur Diagnose) an die übergeordnete Einheit und/oder an ein mobiles Endgerät wie ein Smartphone, ein Tablet oder ein für die Prozessautomatisierung spezifisches mobiles Endgerät wie der von Endress+Hauser vertriebene FieldXpert übertragen werden.

Dies hat den großen Vorteil, dass prinzipiell kein Kabel- oder Drahtanschluss mehr zu dem prozessnahen Feldgerät geführt werden muss. Über einen Kabel- oder Drahtanschluss erfolgt jedoch üblicherweise auch die Versorgung des Feldgeräts mit der von ihm benötigten elektrischen Energie, beispielsweise indem das Feldgerät über eine Zwei- oder Vierdrahtleitung an eine externe Energieversorgungseinheit angeschlossen ist. Daher muss bei einem Wegfall des Kabel- oder Drahtanschlusses die Energieversorgung des Feldgeräts mittels einer internen Energieversorgungseinheit wie beispielweise einer Batterie erfolgen.

Zur Versorgung eines Feldgerät der Automatisierungstechnik wird typischerweise eine Batterie benötigt, welche eine hinreichend konstante Spannungen von zumindest 1,2 V bereitstellt. Eine derartige Batterie ist im Stand der Technik als Rundbatterie bzw. als Rundbatterie-förmige Batterie ausgestaltet, wobei eine rundbatterie-förmige Batterie zum Beispiel auch durch die Verbindung mehrerer Knopfzellen gebildet sein kann.

Hierbei stellt sich die Aufgabe, die Batterie möglichst einfach und platzsparend in das Feldgerät der Automatisierungstechnik zu integrieren. Dabei ist es vorteilhaft, eine Halterung für eine Batterie in der Nähe einer Leiterplatte des Feldgerätes, auf welcher die elektronischen Bauelemente des Feldgeräts angeordnet sind, anzuordnen. Besonders vorteilhaft ist eine Integration der Halterung für eine Batterie in die Leiterplatte.

Aus dem Stand der Technik sind Leiterplatten bekannt, die eine Halterung für eine Batterie aufweisen. So ist zum Beispiel in der US 2010 129 687 A eine Leiterplatte zur Aufnahme einer Knopfzelle bekannt geworden. Eine Leiterplatte mit einer Halterung für rundbatterie-förmigen Batterie für ein Feldgerät ist aus dem chinesischen Gebrauchsmuster CN 2014 79468 U bekannt. Hier weist die Leiterplatte ein Loch auf, in welches ein Teilbereich der Batterie ragt, wodurch eine platzsparende Anordnung der Batterie in der Halterung ermöglicht wird. Zur Befestigung der Batterie wird diese mit einem Fixierband umwickelt, wodurch eine hinreichend feste Fixierung ermöglicht wird. Mittels der Fixierung ist die bekannte Halterung insbesondere auch gegen solche Vibrationen beständig, welche in einer Prozessanlage der Automatisierungstechnik auftreten können. Allerdings ermöglicht die in der CN 2014 79468 U vorgeschlagene Lösung kein einfaches Einsetzen und/oder Auswechseln der Batterie.

Auch bekannt ist eine Leiterplatte mit einer Halterung für eine Batterie mit zwei auf die Leiterplatte aufgelöteten Kontaktelementen, wobei die in die Halterung eingesetzte Batterie zwischen den Kontaktelementen derart eingespannt ist, dass eine die Pole der Batterie verbindende gedachte Gerade im Wesentlichen parallel zu einer Ebene der Leiterplatte ist. Beide Kontaktelemente dienen der Herstellung der elektrischen Verbindung und der Einspannung der Batterie, und sind dazu zumindest abschnittsweise elastisch verformbar. Der elastisch verformbare Abschnitt des Kontaktelements ist dabei im Wesentlichen senkrecht zu der Ebene der Leiterplatte angeordnet, wobei das Kontaktelement mittels einem wiederum zu dem elastisch verformbaren Abschnitt senkrecht angeordneten Abschnitt auf eine Kontaktfläche der Leiterplatte aufgelötet ist.

Um eine derartige Halterung als vibrationsbeständig auszulegen, sind relativ große Einspannkräfte erforderlich. Auch bei einer derartigen Lösung, gerade im Falle hoher Einspannkräfte, gestaltet sich das Einsetzen und/oder das Auswechseln der Batterie als aufwendig. Zudem werden durch die Kontaktelemente die die Batterie einspannenden Kräfte (im Folgenden: Einspannkräfte) im Wesentlichen in einen rechten Winkel auf die Leiterplatte übertragen. Daher wirken die Einspannkräfte in einem ungünstigen Winkel auf die Lötstelle der aufgelöteten Kontaktelemente, nämlich jeweils nicht als senkrecht auf die Lötstelle wirkende Normalkraft, sondern auch in einer dazu parallelen Richtung d.h. als eine Querkraft. Durch die Querkraft kann letztendlich auch die Lötstelle des Kontaktelements geschwächt werden.

Eine Möglichkeit einer Kontaktierung eines Energiespeichers ist in der EP 2 592 913 A1 offenbart worden.

Der Erfindung liegt daher die Aufgabe zugrunde, eine Leiterplatte mit einer Halterung für eine Batterie, insbesondere eine rundbatterie-förmige Batterie, anzugeben, welche platzsparend ist und gleichzeitig ein einfaches Einsetzen und/oder Auswechseln der Batterie ermöglicht. Der Erfindung liegt ferner die Aufgabe zugrunde, ein Gehäuse, insbesondere für ein Feldgerät der Automatisierungstechnik, mit einer erfindungsgemäßen darin angeordneten Leiterplatte sowie ein Verfahren zur Herstellung der erfindungsgemäßen Leiterplatte mit der Halterung anzugeben.

Bezüglich der Leiterplatte wird die Aufgabe gelöst durch die Merkmale von Anspruch 1. Anspruch 1 umfasst eine Halterung für eine Batterie, wobei die Halterung einen ersten und einen zweiten, jeweils an eine Leiterbahn der Leiterplatte angeschlossenen Kontakt aufweist und wobei die Halterung derart ausgebildet ist, dass eine in die Halterung einsetzbare Batterie im eingesetzten Zustand derart zwischen den beiden Kontakten eingespannt ist, dass auf einander gegenüberliegenden Stirnseiten der Batterie angeordnete Pole der Batterie jeweils in elektrisch leitender Verbindung zu einem der beiden Kontakte stehen und dass die zwischen den Kontakten eingespannte Batterie auf einem die Batterie tragenden Trägerbereich der Leiterplatte aufliegt und in Bezug zu der Leiterplatte derart ausgerichtet ist, dass eine die Pole verbindende gedachte Gerade im Wesentlichen parallel zu der Ebene des Trägerbereichs der Leiterplatte angeordnet ist, wobei die Leiterplatte einen starren und mit dem Trägerbereich verbundenen ersten Abschnitt aufweist, der im Wesentlichen senkrecht zu dem Trägerbereich angeordnet ist, und wobei der erste Kontakt auf dem ersten Abschnitt angeordnet ist.

Erfindungsgemäß weist die Leiterplatte also einen Trägerbereich und einen damit verbundenen und dazu senkrecht angeordneten ersten Abschnitt auf, wobei der erste Kontakt auf dem senkrecht zu dem Trägerbereich angeordneten ersten Abschnitt angeordnet ist.

Die Erfindung der Vorteile sind die folgenden:
- Da die Halterung aus dem Trägerbereich und dem dazu senkrecht angeordneten ersten Abschnitt der Leiterplatte geformt bzw. gebildet ist, wird mittels der erfindungsgemäßen Lösung eine Leiterplatte bereitgestellt, in welche die Halterung platzsparend integriert ist. Ein weiterer Vorteil dieser Lösung ist, dass ein derartiger erster Kontakt sehr einfach zu fertigen ist.
- Durch den starren ersten Abschnitt der Leiterplatte herrscht in dem ersten Kontakt bei einer in die Halterung eingesetzten Batterie eine günstige Verteilung der Einspannkräfte. Zum einen werden die Einspannkräfte auf die gesamte Fläche des ersten Abschnitts verteilt. Zum anderen ergibt sich im ersten Kontakt eine zu dem ersten Abschnitt im Wesentlichen senkrechte (d.h. in Richtung der Flächennormalen des ersten Abschnitts zeigende) Übertragung der Einspannkräfte, so dass die Einspannkräfte als eine Normalkraft auf den ersten Kontakt wirken.
- Die günstige Verteilung der Einspannkräfte in dem ersten Kontakt bewirkt ein einfaches Einsetzen und/oder das Auswechseln einer Batterie. Zudem wird dadurch eine höhere Beständigkeit gegenüber Vibrationen erreicht.

Erfindungsgemäß weist die Leiterplatte einen starren und mit dem Trägerbereich verbundenen zweiten Abschnitt auf. Der zweite Abschnitt ist im Wesentlichen senkrecht zu dem Trägerbereich angeordnet, wobei der zweite Kontakt auf dem zweiten Abschnitt angeordnet ist. In dieser Weiterbildung gibt es also zwei zu dem Trägerbereich jeweils senkrecht angeordnete Abschnitte, nämlich den ersten und den zweiten Abschnitt. Je einer der beiden Kontakte ist dabei auf einem der beiden zu dem Trägerbereich senkrecht angeordneten Abschnitte angeordnet. Dabei sind der erste und der zweite Abschnitt jeweils mit einem Ende des Trägerbereichs verbunden, wobei sich die beiden Enden gegenüberliegen. In dieser Weiterbildung liegt die günstige Verteilung und Richtung der Einspannkräfte sowohl für den ersten Kontakt, als auch für den zweiten Kontakt vor.

In einer Weiterbildung der Erfindung umfasst der erste Kontakt eine auf dem ersten Abschnitt angeordnete Kontaktfläche. Die Kontaktfläche dient der elektrischen Verbindung mit einem der Pole einer in die Halterung einsetzbaren Batterie im eingesetzten Zustand derart, dass im eingesetzten Zustand der Pol in unmittelbarer elektrischer Verbindung mit der Kontaktfläche steht. Vorteilhaft an dieser Weiterbildung ist dabei, dass zur Herstellung der elektrischen Verbindung mit einem der Pole der Batterie kein weiteres Kontaktelement benötigt wird, sondern die elektrische Verbindung des ersten Kontakts mit der Batterie unmittelbar zwischen dem Pol und der Kontaktfläche besteht, beispielsweise indem ein Pol der Batterie direkt an der Kontaktfläche anliegt. Die Einspannung der Batterie im eingesetzten Zustand kann dadurch erfolgen, dass zumindest einer der Kontakte der Halterung zumindest ein zumindest abschnittsweise federelastischen Kontaktelement umfasst. In einer Ausgestaltung umfasst der erste Kontakt daher ein der Einspannung und der elektrischen Verbindung dienendes federelastisches oder einen federelastischen Abschnitt aufweisendes erstes Kontaktelement. Alternativ oder zusätzlich umfasst der zweite Kontakt ein der Einspannung und der elektrischen Verbindung dienendes federelastisches oder einen federelastischen Abschnitt aufweisendes zweites Kontaktelement.

In einer Weiterbildung der Erfindung sind/ist das erste Kontaktelement und/oder das zweite Kontaktelement als ein SMD-lötbares Bauelement ausgebildet. Das SMD-Iötbare Bauelement ist jeweils auf einer vorgesehenen Kontaktfläche der Leiterplatte aufgelötet, wobei die vorgesehene Kontaktfläche an die an den jeweiligen Kontakt angeschlossene Leiterbahn angeschlossen ist. SMD ist dabei die Bezeichnung für oberflächenmontierbare Bauelemente (englisch: 'Surface Mounted Devices' oder kurz: SMD). SMDlötbare Bauelemente werden mit Bestückungsautomaten maschinell auf mit Lotpaste versehene Kontaktflächen auf der Leiterplatte platziert und gemeinsam in einem einzigen Reflow-Prozess aufgelötet. In der Weiterbildung mit den SMD-lötbaren Kontaktelementen kann das Auflöten der Kontaktelemente oder des Kontaktelements in den Reflow-Prozess zum Auflöten aller weiteren SMD-lötbaren elektronischen Bauelemente, welche zum Auflöten auf die Leiterplatte vorgesehen sind, integriert werden. Diese Weiterbildung stellt damit eine fertigungstechnisch besonders bevorzugte und dadurch letztendlich auch kostengünstige Lösung dar.

Für den Fall, dass der Kontakt auf einem zu dem Trägerbereich senkrecht angeordneten Abschnitt angeordnet ist (nämlich dem ersten oder dem zweiten Abschnitt) und ein auf die Lötkontaktfläche SMD-aufgelötetes Kontaktelement umfasst, wird in dieser Lösung aufgrund der oben erwähnten lotrechten Kraftübertragung auf die Lötstelle eine hochfeste, SMD-gelötete Lötstelle erhalten. Dadurch wird die Ausfallsicherheit der Lötstelle des Kontakts der Halterung für die Batterie, und damit auch die Ausfallsicherheit der Energieversorgung des Feldgeräts erhöht.

In einer Ausgestaltung der Erfindung handelt es sich bei dem zweiten Kontaktelement um einen in dem Trägerbereich angeordneten Kontaktbügel. Der Kontaktbügel umfasst einen auf die vorgesehene Kontaktfläche aufgelöteten Kontaktbügelfuß und einen der Einspannung und der elektrischen Verbindung dienenden federelastischen Kontaktbügelabschnitt. Die Einspannkräfte im zweiten Kontakt werden daher in einem im Wesentlichen rechten Winkel auf die Leiterplatte übertragen. In dieser Ausgestaltung umfasst der zweite Kontakt einen aus dem Stand der Technik bekannten, standardisiert hergestellten, auf dem Trägerbereich angeordneten und vorzugsweise SMD-lötbaren Kontaktbügel, wohingegen der erste Kontakt erfindungsgemäß auf dem zu dem Trägerbereich senkrecht angeordneten zweiten Abschnitt angeordnet ist und beispielsweise nur durch eine Kontaktfläche gebildet ist, an welcher ein Pol einer in die Halterung eingesetzten Batterie im eingesetzten Zustand anliegt. In dieser Ausgestaltung wird daher der aus dem Stand der Technik bekannte Kontaktbügel auf besonders einfache Art und Weise mit der erfindungsgemäßen Lösung kombiniert.

In einer weiteren Ausgestaltung der Erfindung handelt es sich bei dem ersten Kontaktelement um einen im ersten Abschnitt angeordneten Federkontakt. Alternativ oder zusätzlich handelt es sich bei dem zweiten Kontaktelement um einen im zweiten Abschnitt angeordneten Federkontakt. Die Federkontakt ist dabei jeweils in einem zu dem Trägerbereich senkrecht angeordneten Abschnitt der Leiterplatte angeordnet, nämlich jeweils in dem ersten Abschnitt und/oder dem zweiten Abschnitt. In dieser Ausgestaltung wirken die Einspannkräfte durch den Federkontakt daher im Wesentlichen senkrecht auf den ersten bzw. den zweiten Abschnitt, d.h. als Normalkraft. Bei einem oder beiden der Federkontakte kann es sich zum Beispiel um eine im Wesentlichen zylinderförmige Kontaktfeder, oder aber auch um einen U-förmigen Federkontakt handeln.

Erfindungsgemäß weist der Trägerbereich eine Aussparung auf, in welche die Batterie einsetzbar ist. Die Aussparung ist insbesondere derart bemessen, dass ein Teilbereich der von einer ersten Seite des Trägerbereichs her in die Aussparung eingesetzten und auf der Aussparung aufliegenden Batterie auf einer der ersten Seite gegenüberliegenden zweiten Seite des Trägerbereichs aus dem Trägerbereich herausragt. In dieser vorteilhaften Weiterbildung liegt die in die Halterung einsetzbare Batterie im eingesetzten Zustand also derart auf der Aussparung auf, dass die Batterie mit einem Teilbereich durch die Aussparung ragt. Damit ist auf jeder Seite des Trägerbereichs jeweils ein Teilbereich der Batterie angeordnet. Vorteilhaft handelt es sich in dieser Weiterbildung um eine besonders platzsparende Anordnung der Batterie. Für den Fall, dass die Leiterplatte Teil eines Feldgeräts der Automatisierungstechnik ist, kann damit die Größe des Gehäuses des Feldgeräts bzw. des Feldgeräts insgesamt deutlich reduziert werden.

In einer weiteren besonders vorteilhaften weiteren Weiterbildung ist auf der zweiten Seite des Trägerbereiches mindestens ein Bauelement angeordnet. Die Aussparung, insbesondere die Abmessung der Grundfläche der Aussparung ist derart, dass der aus der Leiterplatte herausragende Teilbereich einer in die Halterung eingesetzten Batterie eine aus dem Trägerbereich herausragende Höhe aufweist, die kleiner ist als die Höhe desjenigen auf der zweiten Seite aufgelöteten Bauelements, welches die größte Bauhöhe aufweist. In dieser besonders vorteilhaften Weiterbildung ist die Aussparung, insbesondere die Abmessung der Grundfläche der Aussparung, an die Bauhöhe des größten Bauelements angepasst. Als Bauhöhe wird die Abmessung der Bauelemente in der zu dem Trägerbereich senkrechten Richtung bezeichnet. Dadurch ragt eine in die Halterung eingesetzte Batterie im eingesetzten Zustand nur soweit durch die Aussparung des Trägerbereichs, dass der auf der zweiten Seite des Trägerbereichs vorhandene Platz, welcher (bedingt durch die Bauhöhe des größten Bauelements) sowieso vorhanden ist, optimal ausgenutzt wird. Damit wird eine besonders platzsparende Anordnung der Batterie in der Halterung ermöglicht.

Erfindungsgemäß sind der Trägerbereich und der dazu senkrecht angeordnete erste Abschnitt durch zwei aneinander angrenzende Bereiche einer starren Leitplatte gebildet, zwischen denen eine eine Knicklinie bildende rinnenförmige Vertiefung in der Leiterplatte vorgesehen ist. Das einmalige Knicken einer Leiterplatte entlang einer rinnenförmigen Vertiefung kann beispielsweise mit einer aus dem Stand der Technik bekannten Leiterplatte erfolgen, welche eine rinnenförmige Vertiefung zwischen zwei ebenen, starren Leiterplattenbereichen aufweist. Eine derartige Leiterplatte wird auch als semi-flexible bzw. Semiflex Leiterplatte bezeichnet. Beispielsweise vertreibt der Leiterplattenhersteller Würth eine derartige Leiterplatte unter dem Handelsnamen "WIRELAID", welche verstärkende Kupferstrukturen, beispielsweise für die die Knicklinie querenden Leiterbahnen aufweist. Damit ist das in der Erfindung erforderliche einmalige Knicken einer Leiterplatte problemlos möglich, ohne dass eine Schädigung der die Knicklinie querenden Leiterbahnen erfolgt.

Erfindungsgemäß sind der Trägerbereich und der dazu senkrecht angeordnete zweite Abschnitt durch zwei aneinander angrenzende Bereiche einer starren Leitplatte gebildet, zwischen denen eine eine Knicklinie bildende rinnenförmige Vertiefung in der Leiterplatte vorgesehen ist.

In einer Ausgestaltung weist die Leiterplatte für jeden vorgesehenen zu dem Trägerbereich senkrecht angeordneten Abschnitt, nämlich für den ersten Abschnitt oder für den ersten Abschnitt und den zweiten Abschnitt, jeweils eine Arretierung, insbesondere eine auf der Leiterplatte angeordnete Arretierung, auf. Die Arretierung fixiert den jeweiligen Abschnitt in dessen Ausrichtung senkrecht zu dem Trägerbereich der Leiterplatte. Für die Arretierung gibt es prinzipiell keine Einschränkung, sie kann beispielsweise als eine auf die Leiterplatte aufgebrachte (gegebenenfalls mittels eines Fügemittels) arretierende Stütze ausgebildet sein. Alternativ kann beispielsweise die Arretierung auch durch eine ausgehärtete Vergussmasse gebildet sein, welche beispielsweise in einem Spritzgussverfahren auf einen vorgegebenen Bereich der Leiterplatte aufgebracht wird, oder aber auch durch einen Kleber.

Bezüglich des Gehäuses wird die Aufgabe gelöst durch die Merkmale des Anspruchs 13. Anspruch 13 beinhaltet ein Gehäuse, insbesondere ein Gehäuse eines Feldgeräts der Automatisierungstechnik, mit einer darin angeordneten erfindungsgemäßen Leiterplatte. Das Gehäuse weist für jeden vorgesehenen zu dem Trägerbereich senkrecht angeordneten Abschnitt, nämlich für den ersten Abschnitt oder für den ersten Abschnitt und den zweiten Abschnitt, jeweils einen Gehäusebereich auf. Die Leiterplatte ist derart in dem Gehäuse angeordnet ist, dass jeweils der Gehäusebereich den jeweiligen Abschnitt der Leiterplatte mittels einer Einfassung mechanisch abstützt und in seiner Ausrichtung senkrecht zu dem Trägerbereich der Leiterplatte fixiert, wobei der jeweilige Abschnitt in die Einfassung des jeweiligen Gehäusebereichs ragt. In dieser Ausgestaltung erfolgt die Fixierung bzw. die Arretierung des zu dem Trägerbereich senkrecht angeordneten Abschnitts mittels des Gehäusebereichs. Dadurch ist für das erfindungsgemäße Gehäuse mit der darin angeordneten Leiterplatte vorteilhaft kein weiteres Mittel zur Arretierung des senkrecht angeordneten Abschnitts vonnöten.

Bezüglich des Verfahrens wird die Aufgabe gelöst durch Anspruch 14. Anspruch 14 beinhaltet ein Verfahren zur Herstellung einer erfindungsgemäßen Leiterplatte mit einer Halterung für eine Batterie. Der Trägerbereich und der/die vorgesehene/n, zu dem Trägerbereich senkrecht angeordnete/n Abschnitt/e, nämlich der erste Abschnitt oder der erste Abschnitt und der zweite Abschnitt, werden aus einer den Trägerbereich und den/die jeweiligen Abschnitt/e aufweisenden starren, ebenen Ausgangs-Leiterplatte erzeugt, indem für jeden Abschnitt jeweils entlang einer Knicklinie eine rinnenförmige Vertiefung in die Ausgangs-Leiterplatte eingebracht, insbesondere eingefräst, wird. Die Knicklinie verläuft zwischen dem Trägerbereich und dem jeweiligen Abschnitt. Anschließend wird für jeden Abschnitt jeweils der jeweilige Abschnitt durch Knicken der Ausgangs-Leiterplatte entlang der jeweiligen Knicklinie aus der gemeinsamen Ebene mit dem Trägerbereich heraus in eine zu dem Trägerbereich senkrechte Anordnung gebracht. Hierbei wird wieder auf die vorstehend erwähnte semi-flexible Leiterplatte als eine mögliche Ausgestaltung für die Ausgangs-Leiterplatte verwiesen. Die Ausgangs-Leiterplatte kann gegebenenfalls noch in weiteren Prozessschritten bearbeitet werden, um eine spezielle Ausgestaltung der erfindungsgemäßen Leiterplatte zu erhalten. Beispielsweise kann auch die Aussparung der erfindungsgemäßen Leiterplatte in die Leiterplatte eingebracht, insbesondere eingefräst, werden. Das Verfahren ist fertigungstechnisch besonders einfach und in diese weiteren Prozessschritte zur Bearbeitung der Ausgangs-Leiterplatte einbindbar.

In einer weiteren Ausgestaltung des Verfahrens wird die rinnenförmige Vertiefung der jeweiligen Knicklinie mit einem runden, rechteckigen oder V-förmigen Profil eingebracht.

Es gibt insbesondere eine erste Seite der Ausgangs-Leiterplatte, auf welcher der Trägerbereich und der erste Abschnitt während des Knickens aneinander angenähert werden. Auf einer dieser ersten Seite der Ausgangs-Leiterplatte gegenüberliegenden, zweiten Seite der Ausgangs-Leiterplatte werden während des Knickens der Trägerbereich und der erste Abschnitt voneinander entfernt. Prinzipiell besteht hierbei im Rahmen der Erfindung keinerlei Einschränkung daran, auf welcher Seite der Ausgangs-Leiterplatte die rinnenförmige Vertiefung der Knicklinie in Bezug zu der ersten oder zweiten Seite angeordnet ist. Die rinnenförmige Vertiefung der Knicklinie kann entweder auf der ersten Seite der Ausgangs-Leiterplatte angeordnet sein, oder auf der zweiten Seite der Ausgangs-Leiterplatte angeordnet sein, welche ersten Seite der Ausgangs-Leiterplatte gegenüberliegt.

Die Erfindung sowie vorteilhafte Ausgestaltungen davon werden nachfolgend anhand von Ausführungsbeispielen näher erläutert, die in den Figuren dargestellt sind. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet.

Es zeigt:

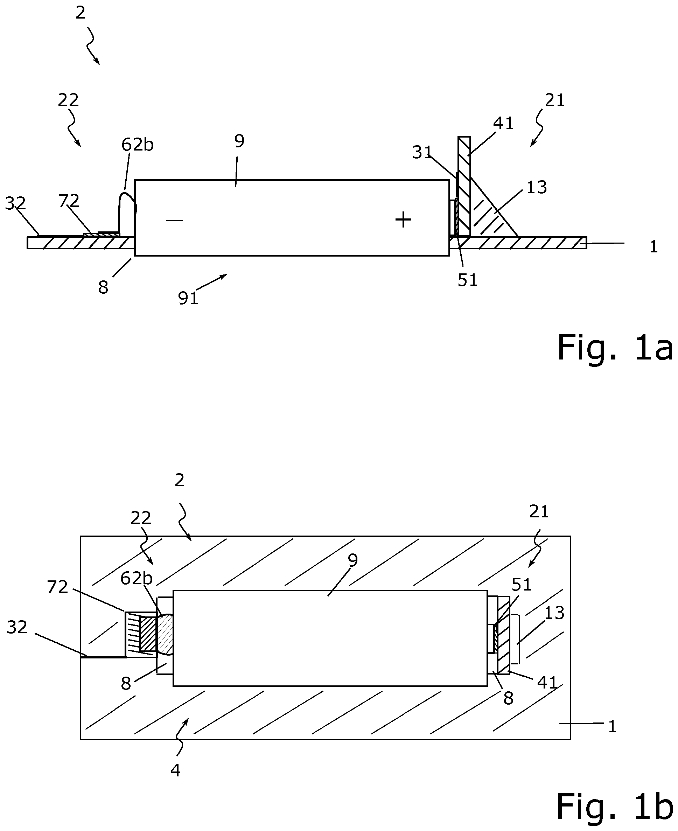

Fig. 1a: eine Schnittansicht eines Ausführungsbeispiels der erfindungsgemäßen Leiterplatte mit einer in die Halterung eingesetzten Batterie;
Fig. 1 b: eine Aufsicht auf das Ausführungsbeispiel aus Fig. 1a der erfindungsgemäßen Leiterplatte mit einer in die Halterung eingesetzten Batterie;
Fig. 2a: eine Schnittansicht eines weiteren Ausführungsbeispiels der erfindungsgemäßen Leiterplatte mit einer in die Halterung eingesetzten Batterie;
Fig. 2b: eine Aufsicht auf das weitere Ausführungsbeispiel aus Fig. 2a der erfindungsgemäßen Leiterplatte mit einer in die Halterung eingesetzten Batterie;
Fig. 2c: eine Schnittansicht eines weiteren Ausführungsbeispiels der erfindungsgemäßen Leiterplatte mit einer in die Halterung eingesetzten Batterie;
Fig. 3a: eine Aufsicht auf ein Ausführungsbeispiel der bei dem Verfahren zur Herstellung der erfindungsgemäßen Leiterplatte verwendeten Ausgangs-Leiterplatte;
Fig. 3b: eine Aufsicht auf ein weiteres Ausführungsbeispiel der bei dem Verfahren zur Herstellung der erfindungsgemäßen Leiterplatte verwendeten Ausgangs-Leiterplatte;
Fig. 4a: eine Schnittansicht einer Ausgestaltung des Ausführungsbeispiels der in Fig. 3b gezeigten Ausgangs-Leiterplatte;
Fig. 4b: eine Schnittansicht einer weiteren Ausgestaltung des Ausführungsbeispiels der in Fig. 3b gezeigten Ausgangs-Leiterplatte;
Fig. 5: ein weiteres Ausführungsbeispiel des Verfahrens zur Herstellung der erfindungsgemäßen Leiterplatte;
Fig. 6a: eine perspektivische Ansicht eines Ausführungsbeispiels des Gehäuses und der darin angeordneten erfindungsgemäßen Leiterplatte;
Fig. 6b: eine perspektivische Ansicht eines weiteren Ausführungsbeispiel des Gehäuses und der darin angeordneten erfindungsgemäßen Leiterplatte.

In den Figuren 1a, 1b ist ein Ausführungsbeispiel der erfindungsgemäßen Leiterplatte 1 mit einer in die Halterung 2 eingesetzten Batterie 9 dargestellt, wobei Fig. 1a eine Schnittansicht und Fig. 1b eine Aufsicht zeigt.

Die Halterung 2 für die Batterie 9 wird unter anderem durch einen Trägerbereich 4, einen dazu senkrecht angeordneten ersten Abschnitt 41 und die Kontakte 21,22 gebildet, wobei die Batterie 9 im eingesetzten Zustand auf dem Trägerbereich 4 aufliegt. Der erste Abschnitt 41 wird dabei durch eine mechanische Arretierung 13, welche auf die Leiterplatte 1 aufgebracht ist, in seiner im Wesentlichen senkrechten Ausrichtung in Bezug zu dem Trägerbereich 4 fixiert. Alternativ kann die Arretierung 13 auch durch eine ausgehärtete Vergussmasse gebildet sein, welche beispielsweise in einem Spritzgussverfahren auf einen vorgegebenen Bereich der Leiterplatte 1 aufgebracht wird, oder aber auch durch einen Kleber.

Der erste Kontakt 21 weist dabei eine Kontaktfläche 51 auf, an welche ein erster Pol der in der Halterung 2 eingesetzten Batterie 9 im eingesetzten Zustand unmittelbar anliegt. Die Kontaktfläche 51 ist dabei an eine Leiterbahn 31 angeschlossen. Dadurch wird eine elektrische Verbindung des ersten Poles der Batterie 9 mit der Leiterplatte 1 hergestellt, wobei hier jeweils nur ein Ausschnitt des relevanten Bereichs der Leiterplatte 1 dargestellt ist.

Der zweite Kontakt 22 weist eine auf dem Trägerbereich 4 angeordnete Kontaktfläche 72 und ein auf die Kontaktfläche 72 aufgelötetes Kontaktelement 62 auf. Das Kontaktelement ist in diesem Ausführungsbeispiel ein aus dem Stand der Technik an sich bekannter, SMD-lötbarer und abschnittsweise elastisch verformbarer Kontaktbügel 62b, welcher einen auf die Kontaktfläche 72 aufgelöteten Kontaktbügelfuß und einen federelastischen Abschnitt umfasst. Auch die Kontaktfläche 72 ist dabei an eine Leiterbahn 32 angeschlossen.

Der federelastische Abschnitt des Kontaktbügels 62b dient der Herstellung der elektrischen Verbindung mit einem Pol der Batterie 9 sowie der Einspannung der Batterie 9 zwischen die beiden Kontakten 21,22 der Halterung 2. Dadurch können die elektronischen Bauelemente BE, welche auf einer ersten und/oder zweiten Oberfläche der Leiterplatte 1 angeordnet bzw. aufgelötetet sind, von der in der Halterung 2 eingesetzten Batterie 9 mit Energie versorgt werden, wobei das Einsetzten und/oder das Austauschen der Batterie 9 in die erfindungsgemäße Halterung 2 ohne weiteres möglich ist.

Gleichzeitig wird mittels des ersten Abschnitts 41 der Leiterplatte in dem ersten Kontakt 21 eine ideale Verteilung bzw. Weiterleitung der Einspannkräfte gewährleistet. In dieser Ausführung der Erfindung ist die federelastische Einspannung durch den federelastischen Abschnitt des Kontaktbügels 62b gegeben. Der Kontaktbügel 62b ist dabei als ein SMD-lötbarer Kontaktbügel 62b ausgestaltet, so dass die Anordnung des Kontaktbügels 62b des zweiten Kontakts 22 der Halterung 2 fertigungstechnisch einfach in den gemeinsamen Reflow-Lötprozess aller SMD-lötbaren Bauelemente BE einbindbar ist.

Des Weiteren ist in diesem Ausführungsbeispiel eine Aussparung 8 in die Leiterplatte 1 eingebracht, wobei die Aussparung 8 in dem Trägerbereich 4 der Leiterplatte 1 angeordnet ist. Die Ausparung 8 kann in diesem Ausführungsbeispiel (wie auch in anderen Ausführungen der Erfindung) beispielsweise eingefräst werden, oder mittels anderer aus dem Stand der Technik bekannter Bearbeitungsmethoden in die Leiterplatte 1 eingebracht werden. Die Abmessung der Aussparung 8 ist an die zum Einsetzen in die Halterung 2 vorgesehene Batterie 9 derart angepasst, dass ein Teilbereich 91 der Batterie 9 durch die Aussparung 8 ragt; dies ist in der Schnittansicht aus Fig. 1a sowie auch aus der Aufsicht aus Fig. 1b ersichtlich. Dadurch wird eine platzsparende Anordnung der Batterie 9 ermöglicht, dies ist insbesondere dann vorteilhaft, wenn die Leiterplatte 1 Teil eines Feldgerätes der Automatisierungstechnik ist.

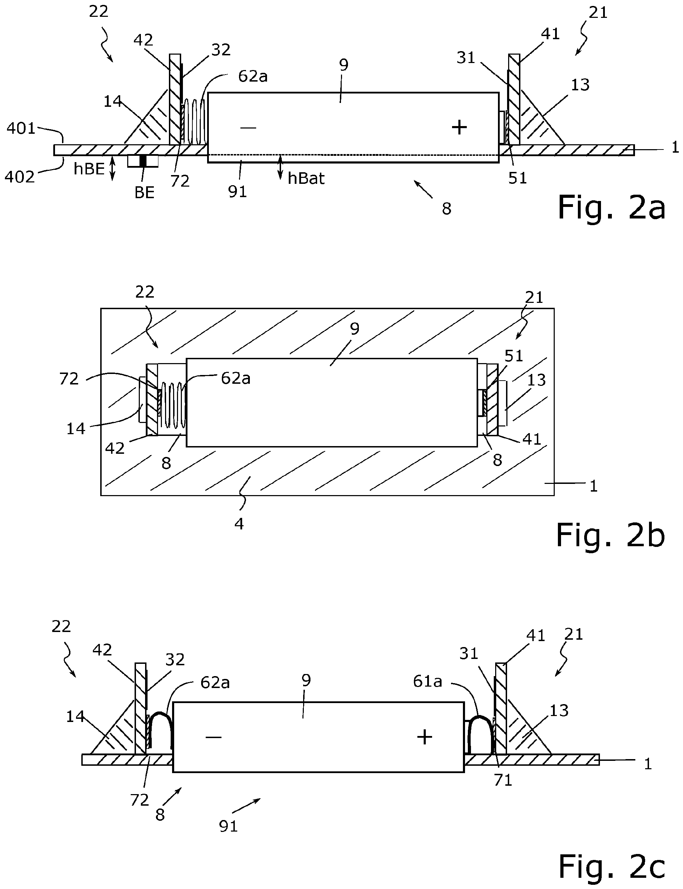

In den Figuren 2a und 2b ist eine zu der in den Fig. 1a,b gezeigten Ausführung alternative Ausführung der erfindungsgemäßen Leiterplatte 1 mit einer in die Halterung 2 eingesetzten Batterie 9 dargestellt. Fig. 2a zeigt eine Schnittansicht, während Fig. 2b eine Aufsicht zeigt.

Der erste Kontakt 21 des in Fig. 2a, b gezeigten Ausführungsbeispiels ist dabei ähnlich zu dem in Fig. 1a, b gezeigten Ausführungsbeispiel ausgeführt, da er auch durch einen, zum Trägerbereich 4 senkrecht angeordneten ersten Abschnitt 41 aufweist, wobei hier zudem der zweite Kontakt 22 nun unter anderem durch einen weiteren, zum Trägerbereich 4 senkrecht angeordneten Abschnitt, nämlich den zweiten Abschnitt 42, gebildet ist.

Der zweite Abschnitt 42 wird dabei durch eine Arretierung 14 in seiner senkrechten Ausrichtung zum Trägerbereich 4 gehalten, welche auf die gleiche Art wie die in Zusammenhang mit Fig. 1a, b erwähnte Arretierung 13 des ersten Kontakts 21 aufgebracht bzw. ausgebildet sein kann. Zur Einspannung weist der zweite Kontakt 22 dabei einen weiteren Federkontakt 62a auf, wobei es sich bei dem weiteren Federkontakt 62a um eine im Wesentlichen zylinderförmige Kontaktfeder handelt, welche auf eine in dem zweiten Abschnitt 42 angeordnete Kontaktfläche 72 SMD-aufgelötet ist. Vorteilhaft wirken dabei in dieser Ausführung in jedem der beiden Kontakte 21,22 die Einspannkräfte nur als Normalkraft auf die Kontaktflächen 51,72.

Auch in dem in Fig. 2a, b gezeigten Ausführungsbeispiel ist die eingangs in Fig. 1a, b gezeigte Aussparung 8 in den Trägerbereich 4 der Leiterplatte 1 eingebracht. In dem Ausführungsbeispiel in Fig. 2a, b ist zusätzlich ein Bauelement BE mit einer Bauhöhe hBE in der zu der Trägerbereich 4 senkrechten Richtung dargestellt. Dabei ist das Bauelement BE auf die zweite Seite 402 des Trägerbereichs 4 aufgelötet, wobei die Batterie 9 von der ersten Seite 401 des Trägerbereichs 4 her in die Halterung 2 einsetzbar ist.

Die Batterie ragt mit einer herausragende Höhe hBat durch die Aussparung 8 des Trägerbereichs 4 hindurch. Dabei ist die Abmessung der Aussparung 8 der Halterung 2 derart an die zum Auflöten auf die Seite 402 des Trägerbereichs 4 vorgesehenen Bauelemente sowie an die Batterie 9 angepasst, dass die herausragende Höhe hBat kleiner gleich die Bauhöhe hBE desjenigen auf der zweiten Seite 402 aufgelöteten bzw. zum Auflöten vorgesehenen Bauelementes BE ist, welches die größte Bauhöhe aufweist, d.h. die größte Bauhöhe im Vergleich zu allen weiteren auf der zweiten Seite 402 aufgelöteten bzw. zum Auflöten vorgesehenen Bauelemente. Das Bauelement BE bzw. die Anpassung der Aussparung 8 an die Bauhöhe hBE und die Batterie 9 kann selbstverständlich auch dem vorherigen Ausführungsbeispiel aus den Fig. 1a, b hinzugefügt werden.

Gegebenenfalls kann in der Ausführung der Erfindung mit den zwei zu dem Trägerbereich 4 senkrecht angeordneten Abschnitten 41,42 die Halterung 2 auch jeweils einen Federkontakt 61a,62a in jeweils dem ersten Kontakt 21 und in dem zweiten Kontakt 22 aufweisen. Dieses weitere Ausführungsbeispiel ist in einer Schnittansicht in Fig. 2c dargestellt. Bei beiden Federkontakten 61a,62a handelt es sich in diesem Ausführungsbeispiel um auf die Kontaktflächen 71,72 SMD-aufgelötete Federkontakte 61a,62a, welche hier im Wesentlichen U-förmig ausgestaltet sind. Diese können beispielsweise in einem einzigen Reflow-Prozess zusammen mit allen SMD-lötbaren Bauelementen auf jeweils eine Kontaktfläche 31 des ersten Kontakts 21 bzw. auf eine Kontaktfläche 32 des zweiten Kontakts 22 der Leiterplatte 1 aufgelötet werden. Selbstverständlich kann alternativ auch, falls der erste Kontakt 21 ähnlich wie in dem in Fig. 2a,2b gezeigten Ausführungsbeispiel ausgeführt ist, nur der zweite Kontakt 22 einen im Wesentlichen U-förmigen Federkontakt 62a aufweisen. In dem ersten Kontakt 21 liegt dann (siehe Fig. 2a) ein Pol der Batterie 9 unmittelbar an einer Kontaktfläche 51 an.

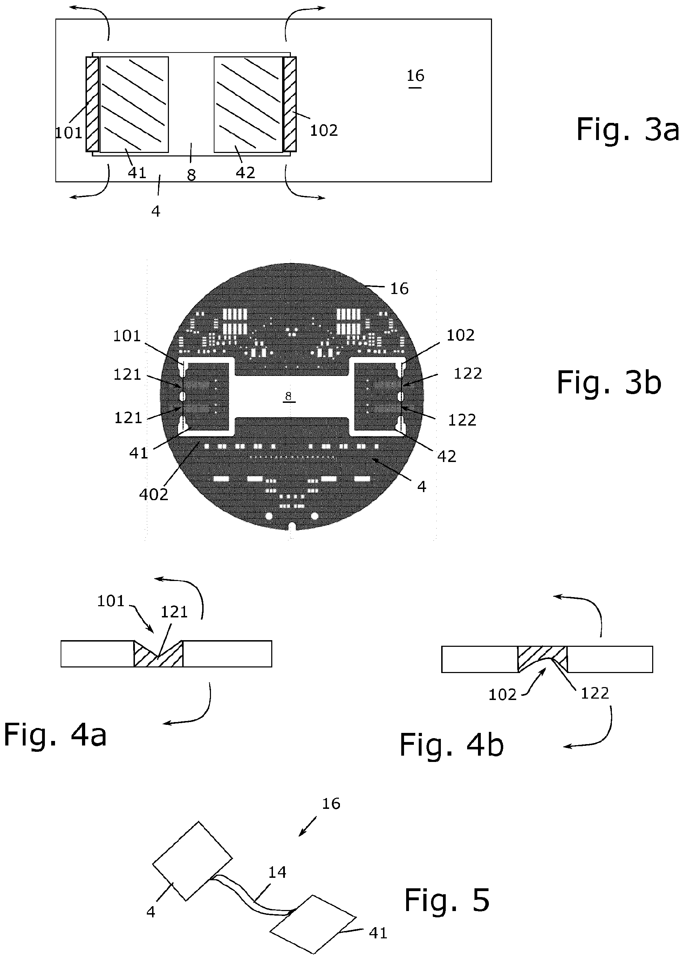

In den Figuren 3-5 sind Ausführungsbeispiele eines Verfahrens dargestellt, mit dem die erfindungsgemäße Leiterplatte 1 herstellbar ist; insbesondere Ausführungsbeispiele eines Verfahrens, um den zu dem Trägerbereich 4 senkrecht angeordneten und mit dem Trägerbereich 4 verbundenen ersten Abschnitt 41 oder alternativ den ersten Abschnitt 41 und den zweiten Abschnitt 42 zu erhalten.

Insbesondere ist in Fig. 3a eine Aufsicht auf eine schematische Darstellung einer Ausgangs-Leiterplatte 16 gezeigt. In der starren und ebenen Ausgangs-Leiterplatte 16 sind dabei der Trägerbereich 4, der erste Abschnitt 41 und der zweite Abschnitt 42 zunächst in einer gemeinsamen Ebene angeordnet. In die Ausgangs-Leiterplatte 16 werden zwei rinnenförmige Vertiefungen 121,122 eingefräst, welche jeweils eine Knicklinie 101,102 bilden. Die rinnenförmigen Vertiefungen 121,122 können dabei gegebenenfalls gleichzeitig mit der Ausparung 8 in die Ausgangs-Leiterplatte 16 eingefräst werden. Durch das Knicken der Ausgangs-Leiterplatte 16 entlang der Knicklinie 101,102 werden dabei die zueinander senkrecht angeordneten Bereiche d.h. der Trägerbereich 4 und der erste Abschnitt 41 und gegebenenfalls der Trägerbereich 4 und der zweite Abschnitt 42 der erfindungsgemäßen Leiterplatte 1 erhalten. Dabei ist anhand der Pfeile jeweils noch eine bei dem Knicken vorliegende Knickrichtung angedeutet.

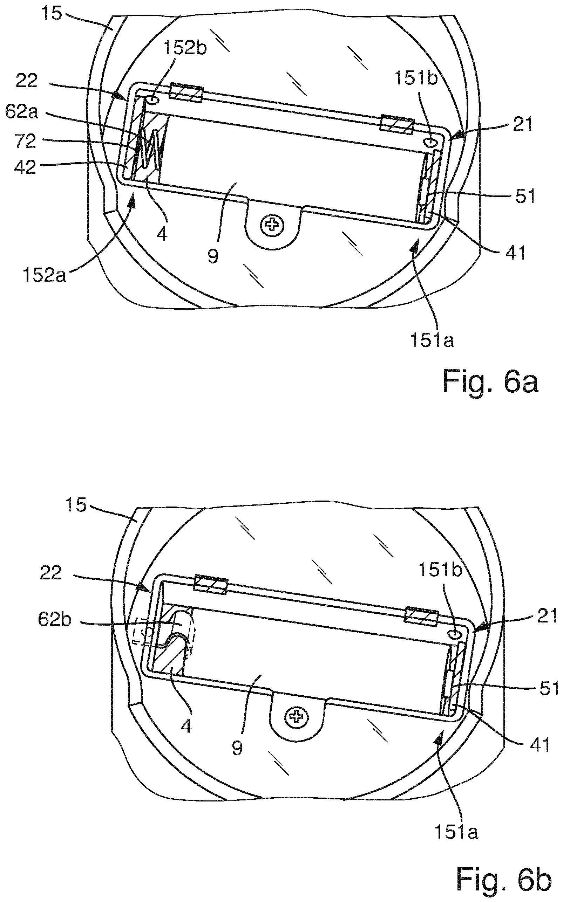

In Fig. 3b ist eine Aufsicht auf eine zur Fig. 3a ähnliche Ausgestaltung gezeigt, wobei hier eine detailliertere Darstellung der Ausgangs-Leiterplatte 16 gezeigt ist. Insbesondere ist die Ausgangs-Leiterplatte 16 derart bearbeitet, dass sie in dem Gehäuse 15 (siehe auch Fig. 6a und 6b) anordenbar ist. Die Aufsicht aus Fig. 3b zeigt hierbei die Unterseite bzw. die zweite Seite 402 des Trägerbereichs 4, auf welcher Kontaktflächen für darauf aufzulötende Bauelemente angedeutet sind. Gleichzeitig ist eine Aufsicht auf die rinnenförmigen Vertiefungen 121,122 gezeigt, welche auch im Detail in der Schnittansicht in Fig. 4a und Fig. 4b gezeigt sind.

In einer ersten, in Fig. 4a gezeigten Ausführung liegt hier eine Knicklinie 101 mit einer rinnenförmigen Vertiefung 121 vor, die mit einem im Wesentlichen V-förmigen Profil eingebracht wird. In der Erfindung herrschen keinerlei Einschränkungen daran, auf welcher Seite der Ausgangs-Leiterplatte 16 die rinnenförmige Vertiefung 121,122 der Knicklinie 101,102 angeordnet ist. Daher ist das Knicken der Leiterplatte, wie in Fig. 4a anhand der Pfeile angedeutet, in beide Richtungen möglich, d.h. sowohl in eine die rinnenförmige Vertiefung 121 öffnende Richtung oder in eine die rinnenförmige Vertiefung 121 schließende Richtung. In der Ausführung in Fig. 4a weist die rinnenförmige Vertiefung 121 eine im Wesentliches V-förmiges Profil auf, hier mit einem Öffnungswinkel von ca. 120°. Dagegen ist einer alternativen Ausführung in Fig. 4b das Profil der rinnenförmigen Vertiefung 122 im Wesentlichen U-förmig. gegenüberliegenden Seite der Ausgangs-Leiterplatte angeordnet; selbstverständlich kann das Profil der rinnenförmigen Vertiefung 122 auch rechteckförmig sein.

Da die Leiterbahnen 31,32 (hier nicht gezeigt) die Knicklinien 101,102 queren, muss sichergestellt sein, dass bei dem einmaligen Knicken der Ausgangs-Leiterplatte 16 die Leiterbahnen nicht geschädigt werden. Dies kann durch eine lagenartigen Aufbau der Ausgangs-Leiterplatte 16 erreicht werden, in welche eine Verstärkung mit Kupferstrukturen mit einer Dicke von einigen 100 Mikrometern eingearbeitet ist (hier nicht dargestellt). Dies ist beispielsweise der Fall bei einer unter dem Handelsnamen "WIRELAID" vertriebenen und gegebenenfalls zusätzlich für die Erfindung speziell bearbeiteten semi-flexiblen Ausgangs-Leiterplatte 16.

Alternativ ist es möglich, wie in Fig. 5 dargestellt, eine Ausgangs-Leiterplatte mit verschiedenen starren und ebenen Abschnitten, die über einen flexiblen Leiterplattenbereich 14 miteinander verbunden sind, zu verwenden. Eine derartige starrflexible Leiterplatte Ausgangs-Leiterplatte 16 erlaubt eine im Wesentlichen beliebige Anordnung der starren und ebenen Abschnitte. So kann zum Beispiel der Trägerbereich 4 durch einen ersten starren Abschnitt der starr-flexiblen Leiterplatte und der dazu senkrecht anzuordnende erste Abschnitt 41 durch einen über den flexiblen Leiterplattenbereich 14 damit verbundenen zweiten starren Abschnitt gebildet sein. Selbstverständlich sind auch Kombinationen der in den Figuren 3a,b, 4 und 5 dargestellten Ausführungsbeispiele möglich, indem beispielsweise der erste Abschnitt 41 bzw. dessen senkrechte Anordnung zum Trägerbereich 4 wie in Fig. 3a,b und Fig. 4 dargestellt gezeigt erhalten wird, und der zweite Abschnitt 42 bzw. dessen senkrechte Anordnung zum Trägerbereich 4 wie in Fig. 5. dargestellt erhalten wird.

In den Figuren 6a und 6b sind perspektivische Ansichten von Ausführungsbeispielen eines Gehäuse 15 mit jeweils einer darin angeordneten erfindungsgemäßen Leiterplatte 1, und jeweils mit einer in die Halterung 2 der Leiterplatte 1 eingesetzten Batterie 9 gezeigt. Bei dem Gehäuse 15 handelt es sich um ein Gehäuse 15 eines Feldgerätes der Automatisierungstechnik.

In Fig. 6a ist dabei eine Leiterplatte 1 in dem Gehäuse 15 angeordnet, welche ähnlich zu der in Fig. 2a, b gezeigten Leiterplatte 1 ausgeführt ist. Im Unterschied zu der in Fig. 2a, 2b gezeigten Ausführung ist in dieser Variante der Erfindung keine Arretierung 13, 14 auf die Leiterplatte1 aufgebracht. Stattdessen werden der erste Abschnitt 41 und der zweite Abschnitt 42 der Leiterplatte 1 in ihrer zu dem Trägerbereich 4 im Wesentlichen senkrechten Ausrichtung mittels des Gehäuses 15 abgestützt. Dabei ist für jeden der jeweils zu dem Trägerbereich 4 im Wesentlichen senkrecht angeordneten Abschnitte 41,42 ein den Abschnitt 41,42 jeweils abstützender Gehäusebereich 151a,152a vorgesehen. Der abstützende Gehäusebereich 151a,152a weist dabei jeweils noch eine Einfassung 151b,152b auf, in die der Abschnitt 41,42 jeweils ragt. Die Einfassung 151b,152b weist beispielsweise wie hier dargestellt eine den Abschnitt 41,42 haltende Erhebung auf, wobei die Erhebung abschnittsweise eine Vollkugel ist. Andere Ausgestaltungen der Einfassung 151b,152b sind selbstverständlich möglich.

In Fig. 6b ist eine weiteres Ausführungsbeispiel eines Gehäuses 15 mit einer darin angeordneten erfindungsgemäßen Leiterplatte 1 mit einer in die Halterung 2 eingesetzten Batterie 9 gezeigt, wobei die Leiterplatte 1 hier ähnlich zu der in Fig. 1a, b gezeigten Leiterplatte 1 ausgeführt ist. In diesem Ausführungsbeispiel weist die Leiterplatte 1 nur einen zu dem Trägerbereich 4 im Wesentlichen senkrecht angeordneten Abschnitt 41 auf, welcher durch den Gehäusebereich 151a in seiner Ausrichtung abgestützt wird. Im Gegensatz zu der in Fig. 1a, b gezeigten Leiterplatte 1 ist dadurch hier keine auf der Leiterplatte aufgebrachte Arretierung 13 für den ersten Abschnitt 41 vonnöten.

Selbstverständlich kann alternativ eine weitere Ausgestaltung der erfindungsgemäßen Leiterplatte 1 in dem Gehäuse 15 angeordnet sein, wie beispielsweise die in Fig. 2c gezeigte Ausführung der erfindungsgemäßen Leiterplatte 1, ähnlich zu der in Fig. 6a gezeigten Anordnung.

### Bezugszeichen und Symbole

- 1: Leiterplatte
- 14: flexibler Leiterplattenbereich
- 2: Halterung
- 21: erster Kontakt
- 22: zweiter Kontakt
- 31,32: Leiterbahn
- 4: Trägerbereich
- 401: erste Seite des Trägerbereichs
- 402: zweite Seite des Trägerbereichs
- 41: erster Abschnitt
- 42: zweiter Abschnitt
- 51: Kontaktfläche
- 61: erstes Kontaktelement
- 61a: Federkontakt
- 62: zweites Kontaktelement
- 62a: Federkontakt
- 62b: Kontaktbügel
- 71,72: Kontaktfläche
- 8: Aussparung
- 9: Batterie
- 101,102: Knicklinie
- 121,122: rinnenförmige Vertiefung
- 13,14: Arretierung
- 15: Gehäuse
- 151a,152a: Gehäusebereich
- 151b,152b: Einfassung
- 16: Ausgangs-Leiterplatte

- BE: Bauelement
- hBE: Bauhöhe des größten Bauelements
- hBat: herausragende Höhe der Batterie

## Patentansprüche

1. Leiterplatte (1) mit einer in die Leiterplatte integrierten Halterung (2) für eine Batterie (9),
wobei die Halterung (2) einen ersten und einen zweiten, jeweils an eine Leiterbahn (31,32) der Leiterplatte angeschlossenen Kontakt (21,22) aufweist und wobei die Halterung (2) derart ausgebildet ist, dass eine in die Halterung (2) einsetzbare Batterie im eingesetzten Zustand derart zwischen den beiden Kontakten (21,22) eingespannt ist,
- dass auf einander gegenüberliegenden Stirnseiten der Batterie (9) angeordnete Pole der Batterie (9) jeweils in elektrisch leitender Verbindung zu einem der beiden Kontakte (21,22) stehen und
- dass die zwischen den Kontakten (21,22) eingespannte Batterie in Bezug zu der Leiterplatte derart ausgerichtet ist, dass eine die Pole verbindende gedachte Gerade im Wesentlichen parallel zu der Ebene eines Trägerbereichs (4) der Leiterplatte angeordnet ist,
wobei die Leiterplatte (1) einen starren und mit dem Trägerbereich (4) verbundenen ersten Abschnitt (41) aufweist, der im Wesentlichen senkrecht zu dem Trägerbereich (4) angeordnet ist, wobei der erste Kontakt (21) auf dem ersten Abschnitt angeordnet (41) ist, wobei die Leiterplatte (1) einen starren und mit dem Trägerbereich (4) verbundenen zweiten Abschnitt (42) aufweist, der im Wesentlichen senkrecht zu dem Trägerbereich (4) angeordnet ist, wobei der zweite Kontakt (22) auf dem zweiten Abschnitt (42) angeordnet ist,
wobei der Trägerbereich (4) und der dazu senkrecht angeordnete erste Abschnitt (41) durch zwei unmittelbar aneinander angrenzende starre Bereiche der Leitplatte (1) gebildet sind, zwischen denen eine eine Knicklinie (101) bildende rinnenförmige Vertiefung (121) in der Leiterplatte (1) vorgesehen ist,
wobei der zweite Abschnitt (42) durch einen unmittelbar an den Trägerbereich (4) angrenzenden starren Bereich der Leitplatte (1) gebildet ist, und wobei zwischen dem Trägerbereich (4) und dem zweiten Abschnitt (42) eine eine Knicklinie (102) bildende rinnenförmige Vertiefung (122) in der Leiterplatte (1) vorgesehen ist,
**dadurch gekennzeichnet, dass**
dass die zwischen den Kontakten (21,22) eingespannte Batterie auf dem die Batterie (9) tragenden Trägerbereich (4) aufliegt
und dass der Trägerbereich (4) eine Aussparung (8) aufweist, in welche Aussparung (8) die Batterie (9) einsetzbar ist, und wobei die Aussparung (8) insbesondere derart bemessen ist, dass ein Teilbereich (91) der von einer ersten Seite (401) des Trägerbereichs (4) her in die Aussparung (8) eingesetzten und auf der Aussparung (8) aufliegenden Batterie (9) auf einer der ersten Seite gegenüberliegenden zweiten Seite (402) des Trägerbereichs (4) aus dem Trägerbereich (4) herausragt.

2. Leiterplatte (1) nach Anspruch 1,
wobei der erste Kontakt (21) eine auf dem ersten Abschnitt (41) angeordnete Kontaktfläche (51) umfasst,
und wobei die Kontaktfläche (51) für die elektrische Verbindung mit einem der Pole einer in die Halterung (2) einsetzbaren Batterie (9) im eingesetzten Zustand derart dient, dass im eingesetzten Zustand der Pol in unmittelbarer elektrischer Verbindung mit der Kontaktfläche (51) steht.

3. Leiterplatte (1) nach zumindest einem der Ansprüche 1 bis 2,
wobei der zweite Kontakt (22) ein der Einspannung und der elektrischen Verbindung dienendes federelastisches oder einen federelastischen Abschnitt aufweisendes Kontaktelement (62,62a,62b) umfasst.

4. Leiterplatte (1) nach Anspruch 3,
wobei das Kontaktelement (62,62a,62b) als ein SMD-lötbares Bauelement ausgebildet ist, welches auf einer auf der Leiterplatte (1) vorgesehenen Kontaktfläche (71;72) aufgelötet ist,
wobei die vorgesehene Kontaktfläche (71;72) an die an den zweiten Kontakt (21,22) angeschlossene Leiterbahn (31;32) angeschlossen ist.

5. Leiterplatte (1) nach zumindest einem der Ansprüche 3 bis 4,
wobei es sich bei dem Kontaktelement (62,62a,62b) um einen im zweiten Abschnitt (42) angeordneten Federkontakt (62a) handelt.

6. Leiterplatte (1) nach zumindest einem der Ansprüche 1 bis 5,
wobei die Leiterplatte (1) für jeden vorgesehenen zu dem Trägerbereich (4) senkrecht angeordneten Abschnitt (41;42), nämlich für den ersten Abschnitt (41) und den zweiten Abschnitt (42), jeweils eine Arretierung (13;14), insbesondere eine auf der Leiterplatte angeordnete Arretierung (13;14), aufweist,
und wobei die Arretierung (13;14) den jeweiligen Abschnitt (41;42) in dessen Ausrichtung senkrecht zu dem Trägerbereich (4) fixiert.

7. Anordnung aus einer Leiterplatte (1) nach zumindest einem der Ansprüche 1 bis 6, einer in die Halterung der Leiterplatte eingesetzten Batterie und mindestens einem Bauelement (BE), das auf der zweiten Seite des Trägerbereiches (402) (BE) aufgelötet ist,
wobei die Aussparung (8), insbesondere die Abmessung der Grundfläche der Aussparung (8), derart ist, dass der aus der Leiterplatte (1) herausragende Teilbereich (91) der Batterie (9) eine aus dem Trägerbereich (4) herausragende Höhe (hBat) aufweist, wobei die herausragende Höhe (hBat) kleiner ist als die Höhe (hBE) des die größte Bauhöhe aufweisenden auf der zweiten Seite aufgelöteten Bauelements (BE).

8. Anordnung umfassend ein Gehäuse (15), insbesondere Gehäuse (15) eines Feldgeräts der Automatisierungstechnik, und eine darin angeordnete Leiterplatte (1) nach zumindest einem der vorherigen Ansprüche 1 bis 6 oder mit einer darin angeordneten Anordnung nach Anspruch 7,
wobei das Gehäuse (15) für jeden vorgesehenen zu dem Trägerbereich (4) senkrecht angeordneten Abschnitt (41;42), nämlich für den ersten Abschnitt (41) oder für den ersten Abschnitt (41) und den zweiten Abschnitt (42), jeweils einen Gehäusebereich (151,152) aufweist und die Leiterplatte (1) derart in dem Gehäuse (15) angeordnet ist,
dass jeweils der Gehäusebereich (151a;152a) den jeweiligen Abschnitt (41;42) der Leiterplatte (1) mittels einer Einfassung (151b;152b) mechanisch abstützt und in seiner Ausrichtung senkrecht zu dem Trägerbereich (4) der Leiterplatte (1) fixiert, wobei der jeweilige Abschnitt (41;42) in die Einfassung (151b;152b) des jeweiligen Gehäusebereichs (151a;152a) ragt.

9. Verfahren zur Herstellung einer Leiterplatte (1) mit einer in die Leiterplatte integrierten Halterung für eine Batterie (9) nach zumindest einem der Ansprüche 1 bis 6,
wobei der Trägerbereich (4) und die vorgesehenen, zu dem Trägerbereich (4) senkrecht angeordneten Abschnitte (41;42), nämlich der erste Abschnitt (41) und der zweite Abschnitt (42), aus einer den Trägerbereich und die jeweiligen Abschnitt/e (41;42) aufweisenden starren, ebenen Ausgangs-Leiterplatte (16) erzeugt werden, indem
- für jeden Abschnitt (41;42) jeweils entlang einer Knicklinie (101,102) eine rinnenförmige Vertiefung (121,122) in die Ausgangs-Leiterplatte (16) eingebracht, insbesondere eingefräst, wird, wobei die Knicklinie (101,102) zwischen dem Trägerbereich (4) und dem jeweiligen Abschnitt (41;42) verläuft; und
- für jeden Abschnitt (41;42) jeweils der jeweilige Abschnitt (41;42) durch Knicken der Ausgangs-Leiterplatte (16) entlang der jeweiligen Knicklinie (101,102) aus der gemeinsamen Ebene mit dem Trägerbereich (4) heraus in eine zu dem Trägerbereich (4) senkrechte Anordnung gebracht wird.

10. Verfahren nach Anspruch 9,
wobei die rinnenförmige Vertiefung (121,122) der jeweiligen Knicklinie (101,102) mit einem runden, rechteckigen oder V-förmigen Profil eingebracht wird.

## Claims

1. Printed circuit board (1) with a holder (2) for a battery (9) integrated into the printed circuit board,
wherein the holder (2) has a first and a second contact (21, 22), each connected to a conductor track (31, 32) of the printed circuit board, and wherein the holder (2) is designed in such a way that a battery which can be inserted into the holder (2) is clamped between the two contacts (21, 22) in the inserted state,
- in that poles of the battery (9) arranged on opposite end faces of the battery (9) are each in electrically conductive connection to one of the two contacts (21, 22), and
- that the battery clamped between the contacts (21, 22) is aligned in relation to the printed circuit board in such a way that an imaginary straight line connecting the poles is arranged substantially parallel to the plane of a carrier region (4) of the printed circuit board,
wherein the printed circuit board (1) comprises a rigid first portion (41) connected to the support region (4) and arranged substantially perpendicular to the support region (4), wherein the first contact (21) is arranged (41) on the first portion, wherein the printed circuit board (1) comprises a rigid second portion (42) connected to the support region (4) and arranged substantially perpendicular to the support region (4), wherein the second contact (22) is arranged (42) on the second portion,
wherein the support region (4) and the first section (41) arranged perpendicularly thereto are formed by two directly adjacent rigid regions of the printed circuit board (1), between which a channel-shaped depression (121) forming a bend line (101) is provided in the printed circuit board (1),
wherein the second section (42) is formed by a rigid region of the printed circuit board (1) directly adjoining the carrier region (4), and wherein a channel-shaped depression (122) forming a bend line (102) is provided in the printed circuit board (1) between the carrier region (4) and the second section (42),
**characterized in that**
that the battery clamped between the contacts (21, 22) rests on the carrier region (4) supporting the battery (9)
and **in that** the carrier region (4) has a recess (8), into which recess (8) the battery (9) can be inserted, and wherein the recess (8) is dimensioned in particular such that a partial region (91) of the battery (9) inserted into the recess (8) from a first side (401) of the carrier region (4) and resting on the recess (8) projects out of the carrier region (4) on a second side (402) of the carrier region (4) opposite the first side.

2. Printed circuit board (1) according to claim 1
wherein the first contact (21) comprises a contact surface (51) arranged on the first portion (41),
and wherein the contact surface (51) serves for the electrical connection with one of the poles of a battery (9) insertable into the holder (2) in the inserted state in such a way that in the inserted state the pole is in direct electrical connection with the contact surface (51).

3. Printed circuit board (1) according to at least one of claims 1 to 2,
wherein the second contact (22) comprises a spring-elastic contact element (62, 62a, 62b) serving for clamping and electrical connection or having a spring-elastic section.

4. Printed circuit board (1) according to claim 3,
wherein the contact element (62, 62a, 62b) is designed as an SMD-solderable component which is soldered onto a contact surface (71; 72) provided on the printed circuit board (1),
wherein the provided contact surface (71;72) is connected to the conductor track (31;32) connected to the second contact (21,22).

5. Printed circuit board (1) according to at least one of claims 3 to 4,
wherein the contact element (62, 62a, 62b) is a spring contact (62a) arranged in the second section (42).

6. Printed circuit board (1) according to at least one of claims 1 to 5,
wherein the printed circuit board (1) has a locking device (13; 14), in particular a locking device (13; 14) arranged on the printed circuit board, for each intended section (41; 42) arranged perpendicular to the carrier region (4), namely for the first section (41) and the second section (42),
and wherein the locking device (13; 14) fixes the respective section (41; 42) in its orientation perpendicular to the carrier region (4).

7. Arrangement comprising a printed circuit board (1) according to at least one of claims 1 to 6, a battery inserted into the holder of the printed circuit board and at least one component (BE) which is soldered onto the second side of the carrier region (402) (BE) wherein the recess (8), in particular the dimension of the base area of the recess (8), is such that the partial region (91) of the battery (9) projecting from the printed circuit board (1) has a height (hBat) projecting from the carrier region (4), wherein the projecting height (hBat) is smaller than the height (hBE) of the component (BE) having the greatest overall height and soldered onto the second side

8. Arrangement comprising a housing (15), in particular housing (15) of a field device of automation technology, and a printed circuit board (1) arranged therein according to at least one of the previous claims 1 to 6 or with an arrangement arranged therein according to claim 7,
the housing (15) having a housing region (151, 152) for each intended section (41; 42) arranged perpendicularly to the carrier region (4), namely for the first section (41) or for the first section (41) and the second section (42), and the printed circuit board (1) being arranged in the housing (15) in this way,
in that the housing region (151a; 152a) in each case mechanically supports the respective section (41; 42) of the printed circuit board (1) by means of a surround (151b; 152b) and fixes it in its alignment perpendicular to the carrier region (4) of the printed circuit board (1), the respective section (41; 42) projecting into the surround (151b; 152b) of the respective housing region (151a; 152a).

9. Method for manufacturing a printed circuit board (1) with a holder for a battery (9) integrated in the printed circuit board according to at least one of claims 1 to 6,
wherein the support region (4) and the provided sections (41;42) perpendicular to the support region (4), namely the first section (41) and the second section (42), are formed from a rigid planar output printed circuit board (16) comprising the support region and the respective section(s) (41;42) by
- for each section (41; 42), a channel-shaped depression (121, 122) is made, in particular milled, in the output printed circuit board (16) along a bend line (101, 102), the bend line (101, 102) running between the carrier region (4) and the respective section (41; 42); and
- for each section (41; 42), the respective section (41; 42) is brought out of the common plane with the carrier region (4) into an arrangement perpendicular to the carrier region (4) by bending the output printed circuit board (16) along the respective bending line (101, 102).

10. Method according to claim 9,
wherein the channel-shaped recess (121, 122) of the respective buckling line (101, 102) is formed with a round, rectangular or V-shaped profile.

## Revendications

1. Carte de circuit imprimé (1) avec un support (2) pour une batterie (9) intégré dans la carte de circuit imprimé
le support (2) présentant un premier et un deuxième contact (21, 22) raccordés chacun à une piste conductrice (31, 32) de la carte de circuit imprimé et le support (2) étant conçu de telle sorte qu'une batterie pouvant être insérée dans le support (2) est serrée à l'état inséré entre les deux contacts (21, 22),
- en ce que des pôles de la batterie (9) disposés sur des faces frontales opposées l'une à l'autre sont respectivement en liaison électriquement conductrice avec l'un des deux contacts (21, 22), et
- en ce que la pile serrée entre les contacts (21, 22) est orientée par rapport à la carte de circuit imprimé de telle sorte qu'une droite imaginaire reliant les pôles est disposée sensiblement parallèlement au plan d'une zone de support (4) de la carte de circuit imprimé,
dans lequel la carte de circuit imprimé (1) comprend une première partie (41) rigide et reliée à la zone de support (4), disposée sensiblement perpendiculairement à la zone de support (4), le premier contact (21) étant disposé sur la première partie (41), dans lequel la carte de circuit imprimé (1) comprend une deuxième partie (42) rigide et reliée à la zone de support (4), disposée sensiblement perpendiculairement à la zone de support (4), le deuxième contact (22) étant disposé sur la deuxième partie (42),
la zone de support (4) et la première section (41) disposée perpendiculairement à celle-ci étant formées par deux zones rigides directement adjacentes de la carte de circuit imprimé (1), entre lesquelles est prévu un creux (121) en forme de gouttière formant une ligne d'inflexion (101) dans la carte de circuit imprimé (1),
la deuxième section (42) étant formée par une zone rigide de la carte de circuit imprimé (1) directement adjacente à la zone de support (4), et un renfoncement (122) en forme de gouttière formant une ligne d'inflexion (102) étant prévu dans la carte de circuit imprimé (1) entre la zone de support (4) et la deuxième section (42),
**caractérisé en ce que**
**en ce que** la batterie serrée entre les contacts (21, 22) repose sur la zone de support (4) portant la batterie (9)
et **en ce que** la zone de support (4) présente un évidement (8), évidement (8) dans lequel la batterie (9) peut être insérée, et l'évidement (8) étant notamment dimensionné de telle sorte qu'une zone partielle (91) de la batterie (9) insérée dans l'évidement (8) à partir d'un premier côté (401) de la zone de support (4) et reposant sur l'évidement (8) dépasse de la zone de support (4) sur un deuxième côté (402) de la zone de support (4) opposé au premier côté.

2. Carte de circuit imprimé (1) selon la revendication 1
dans lequel le premier contact (21) comprend une surface de contact (51) disposée sur la première partie (41),
et la surface de contact (51) servant à la liaison électrique avec l'un des pôles d'une batterie (9) pouvant être insérée dans le support (2) à l'état inséré, de telle sorte qu'à l'état inséré, le pôle est en liaison électrique directe avec la surface de contact (51).

3. Carte de circuit imprimé (1) selon au moins l'une des revendications 1 à 2,
dans lequel le deuxième contact (22) comprend un élément de contact (62, 62a, 62b) à élasticité de ressort ou présentant une section à élasticité de ressort servant au serrage et à la connexion électrique.

4. Carte de circuit imprimé (1) selon la revendication 3,
l'élément de contact (62, 62a, 62b) étant réalisé sous la forme d'un composant pouvant être soudé SMD, qui est soudé sur une surface de contact (71 ; 72) prévue sur la carte de circuit imprimé (1),
la surface de contact (71 ; 72) prévue étant raccordée à la piste conductrice (31 ; 32) raccordée au deuxième contact (21, 22).

5. Carte de circuit imprimé (1) selon au moins l'une des revendications 3 à 4,
dans lequel l'élément de contact (62, 62a, 62b) est un contact à ressort (62a) disposé dans la deuxième section (42).

6. Carte de circuit imprimé (1) selon au moins l'une des revendications 1 à 5,
la carte de circuit imprimé (1) présentant pour chaque section (41 ; 42) prévue et disposée perpendiculairement à la zone de support (4), à savoir pour la première section (41) et la deuxième section (42), respectivement un dispositif d'arrêt (13 ; 14), en particulier un dispositif d'arrêt (13 ; 14) disposé sur la carte de circuit imprimé,
et dans lequel le dispositif d'arrêt (13 ; 14) fixe la section respective (41 ; 42) dans son orientation perpendiculaire à la zone de support (4).

7. Ensemble constitué d'une carte de circuit imprimé (1) selon au moins l'une des revendications 1 à 6, d'une batterie insérée dans le support de la carte de circuit imprimé et d'au moins un composant (BE) soudé sur la deuxième face de la zone de support (402) (BE)
l'évidement (8), en particulier la dimension de la surface de base de l'évidement (8), étant telle que la zone partielle (91) de la batterie (9) dépassant de la carte de circuit imprimé (1) présente une hauteur (hBat) dépassant de la zone de support (4) , la hauteur dépassante (hBat) étant inférieure à la hauteur (hBE) du composant (BE) brasé sur le deuxième côté et présentant la hauteur de construction la plus élevée

8. Agencement comprenant un boîtier (15), en particulier un boîtier (15) d'un appareil de terrain de la technique d'automatisation, et une carte de circuit imprimé (1) disposée dans celui-ci selon au moins l'une des revendications 1 à 6 précédentes ou avec un agencement disposé dans celui-ci selon la revendication 7,
le boîtier (15) présentant une zone de boîtier (151, 152) pour chaque section (41 ; 42) prévue et disposée perpendiculairement à la zone de support (4), à savoir pour la première section (41) ou pour la première section (41) et la deuxième section (42), et la carte de circuit imprimé (1) étant disposée de cette manière dans le boîtier (15),
en ce que chaque fois la zone de boîtier (151a ; 152a) soutient mécaniquement la section respective (41 ; 42) de la carte de circuit imprimé (1) au moyen d'une bordure (151b ; 152b) et la fixe dans son orientation perpendiculairement à la zone de support (4) de la carte de circuit imprimé (1), la section respective (41 ; 42) faisant saillie dans la bordure (151b; 152b) de la zone de boîtier respective (151a ; 152a).

9. Procédé de fabrication d'une carte de circuit imprimé (1) avec un support intégré dans la carte de circuit imprimé pour une batterie (9) selon au moins l'une des revendications 1 à 6,
la zone de support (4) et les sections (41 ; 42) prévues, disposées perpendiculairement à la zone de support (4), à savoir la première section (41) et la deuxième section (42), étant produites à partir d'une carte de circuit imprimé de sortie plane rigide (16) présentant la zone de support et la ou les sections respectives (41 ; 42), par le fait que
- pour chaque section (41 ; 42), un renfoncement (121, 122) en forme de gouttière est réalisé, en particulier fraisé, dans la carte à circuits imprimés de sortie (16), respectivement le long d'une ligne d'inflexion (101, 102), la ligne d'inflexion (101, 102) s'étendant entre la zone de support (4) et la section respective (41 ; 42) ; et
- pour chaque section (41 ; 42), la section respective (41 ; 42) est amenée par pliage de la carte à circuits imprimés de sortie (16) le long de la ligne de pliage respective (101, 102) hors du plan commun avec la zone de support (4) dans une disposition perpendiculaire à la zone de support (4).

10. Procédé selon la revendication 9,
la cavité en forme de gouttière (121, 122) de la ligne de pliage respective (101, 102) étant réalisée avec un profil rond, rectangulaire ou en forme de V.
